(19) Europäisches Patentamt
European Patent Office
Office européen des brevets

(11) **EP 4 779 754 A1**

(12) **EUROPEAN PATENT APPLICATION**

(43) Date of publication:
**22.07.2026 Bulletin 2026/30**

(51) International Patent Classification (IPC):
**H01M 10/48** (2006.01)     **G01R 31/367** (2019.01)

(21) Application number: **25227441.0**

(52) Cooperative Patent Classification (CPC):
**H01M 10/486; G01R 31/367**

(22) Date of filing: **29.12.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **14.01.2025 JP 2025004590**
**19.09.2025 JP 2025155921**

(71) Applicant: **Toyota Jidosha Kabushiki Kaisha Toyota-shi, Aichi-ken 471-8571 (JP)**

(72) Inventors:
• **TANEBAYASHI, Yosuke**
  **Toyota-shi, Aichi-ken, 471-8571 (JP)**
• **IMADE, Yuki**
  **Toyota-shi, Aichi-ken, 471-8571 (JP)**
• **NARUSE, Yuuki**
  **Toyota-shi, Aichi-ken, 471-8571 (JP)**

(74) Representative: **Winter, Brandl - Partnerschaft mbB**
**Alois-Steinecker-Straße 22**
**85354 Freising (DE)**

(54) **MANAGEMENT DEVICE**

(57) A management device that manages a battery acquires an internal and external temperature difference saturation value of the battery, at a constant current, based on a current of the battery. The management device also acquires an internal and external temperature difference of the battery, based on the internal and external temperature difference saturation value of the battery that is acquired at the constant current. The management device also acquires the internal temperature of the battery, based on an external temperature of the battery and the internal and external temperature difference of the battery that is acquired.

FIG. 3

**Description**

BACKGROUND OF THE INVENTION

1. Field of the Invention

The present disclosure relates to a management device that manages a battery.

2. Description of Related Art

Japanese Unexamined Patent Application Publication No. 2018-170144 (JP 2018-170144 A) discloses technology for estimating internal temperature of a battery from internal temperature of a battery pack, temperature of an outer face of the battery, battery current, and internal resistance of the battery, using a temperature equivalent circuit model in which thermal resistance and heat capacity are parameters, and a Kalman filter.

SUMMARY OF THE INVENTION

In the above technology, the internal temperature of the battery is estimated by analyzing various types of heat transfer related to the battery, using the temperature equivalent circuit model and the Kalman filter. However, it is difficult to analyze all of heat transfer in a battery. For example, JP 2018-170144 A mentions self-heating of the battery, heat transfer between the air surrounding the battery and the outer face portions of the battery, and heat transfer between a coolant or a heater and the outer face portions of the battery, but does not mention heat transfer between external terminals (fastening portions) of the battery and the outer face portions of the battery whatsoever. Accordingly, it is believed that the internal temperature of the battery estimated by the above technology tends to be higher than the actual internal temperature of the battery.

The present disclosure has been made to solve the above problems, and accordingly an object thereof is to provide a management device that can estimate internal temperature of a battery with high accuracy.

According to one embodiment of the present disclosure, there is provided a management device as described below. The management device is a management device for managing a battery, and is configured to acquire an internal and external temperature difference saturation value of the battery at a constant current, based on a current of the battery, acquire an internal and external temperature difference of the battery, based on the internal and external temperature difference saturation value that is acquired, and acquire an internal temperature of the battery, based on an external temperature of the battery and the internal and external temperature difference of the battery.

According to the present disclosure, a management device that can estimate internal temperature of a battery with high accuracy can be provided.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 is a diagram illustrating a schematic configuration of a vehicle according to an embodiment of the present disclosure;
FIG. 2 is a diagram for describing a rapid charging method according to the embodiment;
FIG. 3 is a diagram illustrating a configuration of a management device according to the embodiment;
FIG. 4 is a diagram for describing a map shown in FIG. 3;
FIG. 5 is a diagram showing data measured during execution of a processing flow shown in FIG. 2;
FIG. 6 is a diagram illustrating a modification of the management device illustrated in FIG. 3; and
FIG. 7 is a flowchart showing a method for setting an initial value of internal and external temperature difference of a battery while a vehicle is parked, in the modification.

DETAILED DESCRIPTION OF EMBODIMENTS

Embodiments of the present disclosure will be described in detail with reference to the drawings. The same or equivalent portions are denoted by the same signs throughout the drawings, and description thereof will not be repeated. In the drawings, directions of three mutually orthogonal axes (X-axis, Y-axis, and Z-axis) are indicated by adding a "+" in the direction indicated by the arrow and a "-" in the opposite direction.

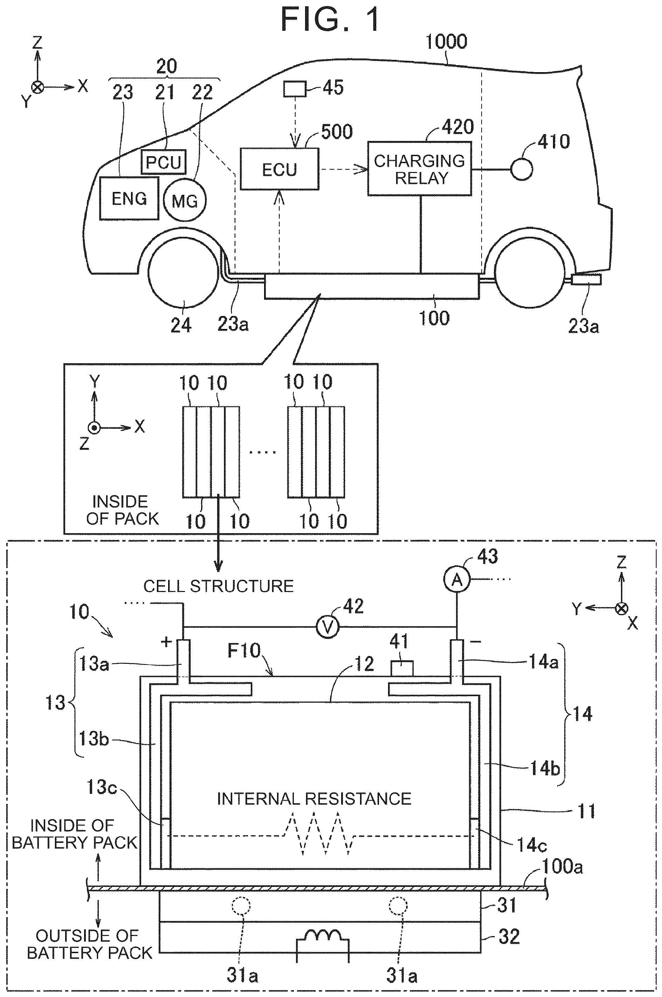

FIG. 1 is a diagram illustrating a configuration of a vehicle according to this embodiment. In FIG. 1, a -X side is equivalent to a traveling direction of the vehicle, and a -Z side is equivalent to a vertical direction (direction of gravity). With reference to FIG. 1, a vehicle 1000 includes a battery pack 100. The battery pack 100 is fixed, for example, under a floor of the vehicle 1000. Note, however, that the battery pack 100 may be installed in any way. For example, a case of the battery pack 100 may make up part of the vehicle body (e.g., floor panel).

The vehicle 1000 further includes an electronic control unit (ECU) 500 that manages the battery pack 100, and various types of sensors (including an outside air temperature sensor 45) that detect a state (position, vehicle speed, etc.) and environment of the vehicle 1000 in real time. The outside air temperature sensor 45 detects ambient temperature of the vehicle 1000 (outside air temperature around the vehicle 1000). Detection results of the various types of sensors are output to the ECU 500. The ECU 500 includes a processor and a storage device. The storage device is configured to be capable of saving information stored therein. In addition to programs, the storage device stores various types of information used by the programs. In the ECU 500, the processor executes the programs that are stored in the storage device to carry out various types of control. The ECU 500 is equivalent to an example of "management device" according to the present disclosure.

The vehicle 1000 further includes a drive device 20 that provides the vehicle 1000 with drive force, and an inlet 410 and a charging relay 420 that are used to charge the battery pack 100.

The drive device 20 includes a power control unit (PCU) 21, a motor generator (MG) 22, and an engine 23. The vehicle 1000 is configured to be capable of traveling using electric power output from the battery pack 100. The vehicle 1000 is, for example, a plug-in hybrid electric vehicle (PHEV). However, the vehicle 1000 may be some other electrified vehicle (xEV), such as a battery electric vehicle (BEV), for example.

The PCU 21 includes an inverter, for example. The MG 22 functions as a traction motor and rotates drive wheels 24 of the vehicle 1000. The PCU 21 drives the MG 22 using electric power supplied from the battery pack 100. Thus, the MG 22 is in a motoring state. The MG 22 in the motoring state converts electric power into torque. The torque is transmitted to the drive wheels 24. Also, the MG 22 enters a regenerative state when vehicle 1000 decelerates, for example, and charges each of batteries that are included in the battery pack 100 through regenerative power generation.

The engine 23 functions as an internal combustion engine and rotates the drive wheels 24 of the vehicle 1000. The engine 23 generates motive power by combustion of fuel supplied from a fuel tank that is omitted from illustration. The motive power generated by the engine 23 is transmitted to the drive wheels 24. An exhaust pipe 23a is connected to the engine 23 and externally discharges exhaust gas of the engine 23 from the vehicle.

The battery pack 100 includes a plurality of cells 10 (power storage cells) each functioning as a secondary battery. A battery stack is formed by stacking the cells 10 in the X direction, for example, and performing constraining thereof. The battery stack is a power storage module in which the cells 10, which are electrically connected, are modularized. In this embodiment, liquid lithium-ion batteries are employed as the cells 10. Note, however, that the cells 10 are not limited to lithium-ion batteries, and may be other secondary batteries such as nickel metal hydride batteries or sodium-ion batteries. The type of secondary batteries is not limited to liquid secondary batteries, and may be an all-solid-state secondary batteries. The battery stack may contain just cells of the same type or may contain cells of different types.

As illustrated in the lower part of FIG. 1, each of the cells 10 includes a case 11, a power storage unit 12 accommodated in the case 11, a positive terminal 13, and a negative terminal 14. The case 11 is, for example, a rectangular case made of metal, and is fixed to a bottom wall 100a of the battery pack 100. The positive terminal 13 and the negative terminal 14 are also each made of metal. The positive terminal 13 and the negative terminal 14 each have first terminal portions 13a, 14a situated outside the case 11 and second terminal portions 13b, 14b accommodated inside the case 11. Each of the first terminal portions 13a, 14a is a portion that protrudes from the surface (+Z side face F10) of the case 11 and functions as an external terminal. In this embodiment, the first terminal portion and the second terminal portion of each of the positive terminal 13 and the negative terminal 14 are integrally formed and seamlessly connected. However, this is not restrictive, and the first terminal portion and the second terminal portion may be formed separately and then joined together.

The power storage unit 12 includes a laminate of a plurality of cathode sheets and a plurality of anode sheets. This laminate is formed by alternately laminating the cathode sheets and the anode sheets. Each of the cathode sheets includes, for example, a cathode current collector and a cathode active material layer. Each of the anode sheets includes, for example, an anode current collector and an anode active material layer. Each of the electrode sheets may be formed by applying an active material to the surface of a metal foil that serves as a current collector. A separator may be disposed between the cathode sheet and the anode sheet. The case 11 further accommodates an electrolytic solution along with the power storage unit 12. The electrolytic solution may be injected into the case 11 through a liquid injection port (omitted from illustration) that is provided in the case 11, and the liquid injection port may be closed after injection. The case 11 may be provided with a gas discharge valve.

Note that the laminate functions as an electrode assembly. The electrode assembly included in the power storage unit 12 is not limited to a laminate in which a plurality of the electrode sheets are stacked in one direction, and instead may be a wound assembly (e.g., a wound assembly in which a laminate of alternately disposed cathode sheets and anode sheets is wound).

The power storage unit 12 is provided with current collecting tabs 13c and 14c. Each of the current collecting tabs 13c, 14c is an assembly of a plurality of tabs (e.g., a tab bundle). The electrode sheets and the tabs may be formed separately and then joined together, or may be formed seamlessly and integrally. The current collecting tab 13c is electrically connected to each of the cathode sheets included in the power storage unit 12, and is also electrically connected to the second terminal portion 13b of the positive terminal 13. The current collecting tab 14c is electrically connected to each of the anode sheets included in the power storage unit 12, and is also electrically connected to the second terminal portion 14b of the negative terminal 14. According to this configuration, the potentials of the cathode sheets and the anode sheets included in the power storage unit 12 are output to the first terminal portions 13a, 14a (external terminals) via the current collecting tabs 13c, 14c and the second terminal portions 13b, 14b, respectively.

A temperature sensor 41 for detecting the external temperature of the outside of the cell 10 is provided on the face F10 (outer face) of the case 11. The temperature sensor 41 may be a thermistor. The cell 10 is also provided with a voltage sensor 42 that detects voltage between the positive terminal 13 (first terminal portion 13a) and the negative terminal 14 (first terminal portion 14a). The temperature sensor 41 and the voltage sensor 42 are provided for each of the cells 10.

The battery pack 100 further includes a current sensor 43 that detects current flowing through the cell 10 (power storage unit 12). In this embodiment, all the cells 10 included in the battery pack 100 are connected in series, and current of the same magnitude flows through all of the cells 10. Accordingly, one current sensor 43 may be shared by all the cells 10. However, this is not restrictive, and the battery pack 100 may include a plurality of cells connected in parallel. The current sensor 43 may be provided for each of the cells 10. Detection results of each of the temperature sensor 41, the voltage sensor 42, and the current sensor 43 are output to the ECU 500.

The vehicle 1000 further includes a cooler 31 and a heater 32. The cooler 31 includes a channel 31a through which a thermal transfer medium flows. The thermal transfer medium is pumped by a pump (omitted from illustration) that is controlled by the ECU 500, and flows through the channel 31a. The thermal transfer medium flowing within the channel 31a exchanges heat with all of the cells 10 included in the battery pack 100. The heater 32 heats the thermal transfer medium in response to a request from the ECU 500. The thermal transfer medium flowing through the channel 31a cools the battery pack 100 when the temperature of the battery pack 100 rises. However, when the temperature of the battery pack 100 is low due effects of the weather, the location (e.g., a cold climate), or the like, the thermal transfer medium heated by the heater 32 raises the temperature of the battery pack 100. The cooler 31 and the heater 32 each adjusts the temperature of all of the cells 10 included in the battery pack 100. In this embodiment, water is used as the thermal transfer medium. However, the thermal transfer medium is not limited to water, and may be other liquids (such as antifreeze) or gases (such as carbon dioxide, etc.).

The vehicle 1000 is configured to be capable of receiving supply of direct current electric power from an external power supply facility that is outside of the vehicle, in a parked state, and of charging all of the cells 10 (batteries) included in the battery pack 100 using the direct current electric power while being supplied with the direct current electric power. Hereinafter, this type of charging will be referred to as "rapid charging". Rated output of the power supply facility for rapid charging is, for example, 50 kW or more (current of 125 A or more).

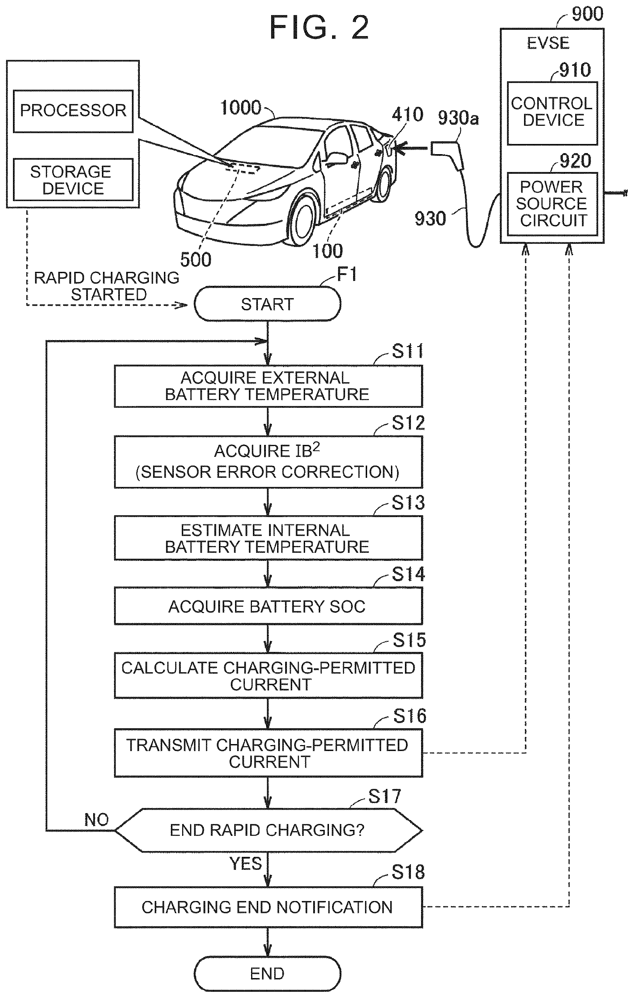

FIG. 2 is a diagram for describing control relating to rapid charging executed by the ECU 500. With reference to FIG. 2, electric vehicle supply equipment (EVSE, power supply facility for vehicles) 900 is configured to be able to supply direct current electric power to the battery pack 100 from outside of the vehicle 1000. Specifically, the EVSE 900 includes a control device 910, a power source circuit 920, and a charging cable 930. The power source circuit 920 is configured to be capable of adjusting the output electric power, and is controlled by the control device 910. The power source circuit 920 outputs the direct current electric power requested by the control device 910 to the charging cable 930. In this embodiment, the EVSE 900 is installed indoors. However, this is not restrictive, and the vehicle 1000 may also carry out rapid charging of the battery pack 100 using a power supply facility installed outdoors.

When the vehicle 1000 is in a parked state, the ECU 500 goes to a stopped state (including a sleep state). Thereafter, when a distal end portion 930a (connector) of the charging cable 930 is connected to the inlet 410 of the vehicle 1000, the ECU 500 is activated. The ECU 500 that is activated then places the charging relay 420 into a connected state (closed state) and also transmits a charging request signal to the control device 910. Thus, the EVSE 900 starts power supply for rapid charging.

The ECU 500 and the control device 910 may communicate with each other by a wired connection via the charging cable 930, or may communicate with each other wirelessly. The aforementioned charging request signal includes a charging-permitted current. The charging-permitted current indicates an upper limit value of the charging current. The charge request signal requests the EVSE 900 for power supply, but does not permit the EVSE 900 to perform power supply exceeding the charging-permitted current. The control device 910 controls the power source circuit 920 in accordance with the charge request signal that is received. This controls the direct current electric power output from the EVSE 900 such that the current input to the inlet 410 does not exceed the charging-permitted current. The charging-permitted current included in the charge request signal is equivalent to an initial value of the charging-permitted current, and is set to a small value (e.g., value close to 0 A) that can sufficiently suppress deterioration of the cells 10. Note that the initial value of the charging-permitted current may be 0 A. In this case, rapid charging does not start immediately even when the ECU 500 transmits a charge request signal, and rapid charging starts when a charging-permitted current exceeding 0 A is transmitted to the EVSE 900 in S16, which will be described later.

After transmitting the charge request signal, the ECU 500 starts a processing flow F1 shown in FIG. 2. The letter "S" in the flowchart indicates steps.

In the processing flow F1, in S11, the ECU 500 acquires the external temperature of the cell 10 based on the output from the temperature sensor 41. The external temperature of the cell 10 is acquired for each of the cells 10 included in the battery pack 100. In the following step S12, the ECU 500 acquires a squared value of the current of the cell 10 based on the output from the current sensor 43. At this time, the ECU 500 may correct error of the current sensor 43 (e.g., error in output value when no current is flowing) and calculate the squared value of the current using the detection value that is corrected. Hereinafter, the current of the cell 10 may be referred to as "IB".

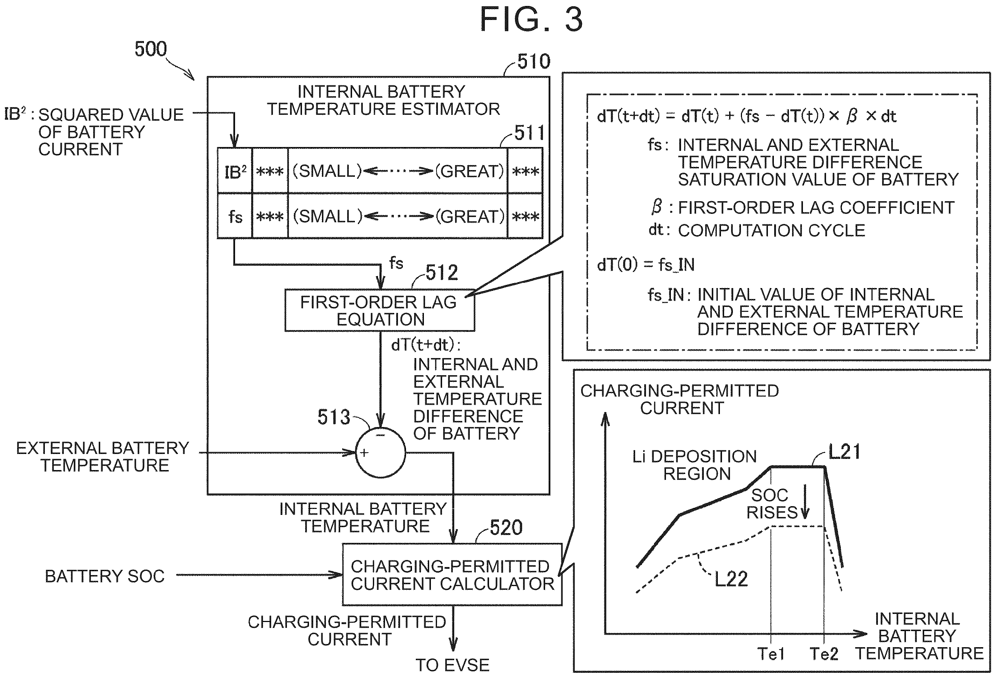

In the following step S13, the ECU 500 acquires internal temperature of the cell 10 using the external temperature of the cell 10 acquired in S11 and the squared value of the current of the cell 10 acquired in S12. The internal temperature of the cell 10 is acquired for each of the cells 10 included in the battery pack 100. Details of S13 will be described later (see FIG. 3). In the following step S14, the ECU 500 acquires a State of Charge (SOC) of the cell 10. The SOC is acquired for each of the cells 10 included in the battery pack 100. The SOC indicates charge status. The charge status is expressed, for example, as a percentage in a range of 0 to 100%, representing the proportion of the current amount of stored power as to the amount of stored power in a fully charged state. As a method for measuring the SOC, a known method such as Coulomb counting or open-circuit voltage (OCV) estimation, for example, can be employed.

In the following step S15, the ECU 500 acquires the charging-permitted current using the internal temperature of the cell 10 acquired in step S13 and the SOC of the cell 10 acquired in step S14. Details of S15 will be described later (see FIG. 3). Subsequently, in S16, the ECU 500 transmits the charging-permitted current that is acquired to the control device 910. When different charging-permitted currents are obtained for the multiple cells 10 included in the battery pack 100 in S15, the ECU 500 transmits the smallest charging-permitted current among the charging-permitted currents acquired for each of the cells 10 to the control device 910 in S16. The control device 910 controls the power source circuit 920 in accordance with the most recently received charging-permitted current. The control device 910 may control the power source circuit 920 such that the current input from the EVSE 900 to the vehicle 1000 (inlet 410) approaches the charging-permitted current.

In the following S17, the ECU 500 determines whether predetermined charging end conditions are satisfied. The charging end conditions are satisfied when the SOC of at least one cell 10 reaches a predetermined value (e.g., SOC value indicating full charge). The charging end conditions may also be satisfied when the user instructs the ECU 500 to stop charging. The charging end conditions can be changed as appropriate. For example, the charging end conditions may be satisfied when a predetermined amount of time has elapsed since the start of rapid charging.

When determination is made that the charging end conditions are not satisfied (NO in S17), the processing returns to S11. Accordingly, during rapid charging (i.e., during period when vehicle 1000 is charging battery using direct current electric power supplied from EVSE 900), the processing of S11 through S17 is repeatedly executed. Hence, the internal temperature of the cell 10 is estimated in S13, and a charging-permitted current based on the latest internal temperature of the cell 10 is transmitted to the EVSE 900 in S16. The EVSE 900 then carries out power supply to the vehicle 1000 in accordance with the latest charging-permitted current. On the other hand, when determination is made that the charging end conditions are satisfied (YES in S17), the ECU 500 notifies the control device 910 of end of charging (notification that rapid charging is to be ended) in S18, and then ends the processing flow F1 shown in FIG. 2. For example, when the SOC of at least one cell 10 reaches the above predetermined value due to rapid charging, determination is made that the charging end conditions are satisfied. Upon receiving the notification of end of charging, the control device 910 controls the power source circuit 920 to stop the power supply from the EVSE 900 to the vehicle 1000.

FIG. 3 is a diagram illustrating a configuration of the ECU 500. With reference to FIG. 3, the ECU 500 includes an internal battery temperature estimator 510 (hereinafter referred to simply as "estimator 510") and a charging-permitted current calculator 520 (hereinafter referred to simply as "calculator 520"). The estimator 510 includes a map 511, a first-order lag equation (mathematical expression) 512 (hereinafter simply referred to as "equation 512"), and a subtractor 513. The map 511 and equation 512 are stored in a storage device of the ECU 500.

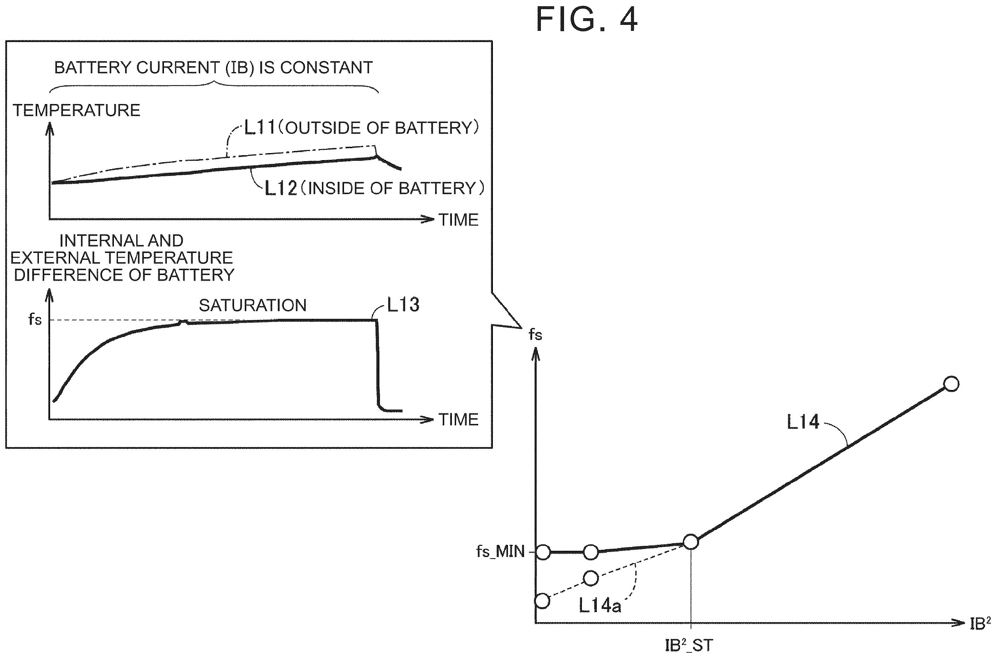

When a current flows through internal resistance of the cell 10 (see FIG. 1), the cell 10 generates heat. It is known that the amount of heat generated inside the cell 10 is proportional to the squared value of the current in the cell 10. However, it was not publicly known that there is a certain correlation between the squared value of the current of the cell 10 (hereinafter referred to as "$IB^2$") and a saturation value of internal and external temperature difference of the cell 10 under a constant current (hereinafter referred to as "fs"), and this was discovered by the inventor of the present application. The map 511 is created based on the above relation that has been confirmed in advance through experiments or simulations. The map 511 shows a relation between $IB^2$ and fs. The map 511 will be described below with reference to FIG. 4. Note that the internal and external temperature difference of the cell 10 is equivalent to difference (absolute value) between the internal temperature of the cell 10 and the external temperature of the cell 10.

FIG. 4 is a diagram for describing the map 511. Lines L11 to L13 in FIG. 4 represent data acquired in a state in which the current value of the cell 10 (and hence $IB^2$) is kept in a constant state. Line L11 indicates transition in the external temperature of the cell 10. Line L12 indicates transition in the internal temperature of the cell 10. Line L13 indicates transition in internal and external temperature difference of the cell 10. On line L13, a saturated value of the internal and external temperature difference of the cell 10 is equivalent to fs for $IB^2$ at that time. By changing $IB^2$ and measuring fs for another $IB^2$ in the same way, fs can be acquired for each of a plurality of $IB^2$s. A predetermined number of combinations of $IB^2$ and fs are acquired in advance through experiments, and are then mapped. A lower limit guard value is then set for experimental data, as necessary. The map 511 is created this way, for example. The map 511 that is created is stored in the storage device of the ECU 500.

Line L14 in FIG. 4 shows an example of the map 511. As shown by line L14, the map 511 defines a relation in which the greater $IB^2$ is, the greater fs is. Note, however, that in a region in which $IB^2$ is equal to or less than a predetermined value ("$IB^2\_ST$" in FIG. 4), fs defined by the map 511 is defined to approach a predetermined lower limit guard value ("fs_MIN" in FIG. 4). In the experimental data indicated by line L14a (dashed line) in FIG. 4, even in a region in which $IB^2$ is small, the greater that $IB^2$ is, the greater fs is. However, in the map 511, the minimum value of fs is defined by the aforementioned lower limit guard value (fs_MIN). The fs indicated by the map 511 is always equal to or greater than the lower limit guard value.

When the vehicle 1000 is left unattended in a parked state for a long period of time after the vehicle 1000 is parked, the internal and external temperature difference of the cell 10 gradually decreases during the unattended period. However, it is unusual that the internal and external temperature difference of the cell 10 will disappear completely before the start of rapid charging. Accordingly, in this embodiment, the lower limit guard value (fs_MIN) is provided. This makes an initial value of the internal and external temperature difference of the cell 10 to be closer to the actual value, making it easier to estimate the internal temperature of the cell 10 with higher accuracy. In this embodiment, the lower limit guard value is a fixed value.

Referring again to FIG. 3, equation 512 is a first-order lag equation for thermal change (heat generation or heat dissipation) of the cell 10. In this embodiment, equation 512 is expressed as follows.

$$dT(t + dt) = dT(t) + (fs - dT(t)) \times \beta \times dt$$

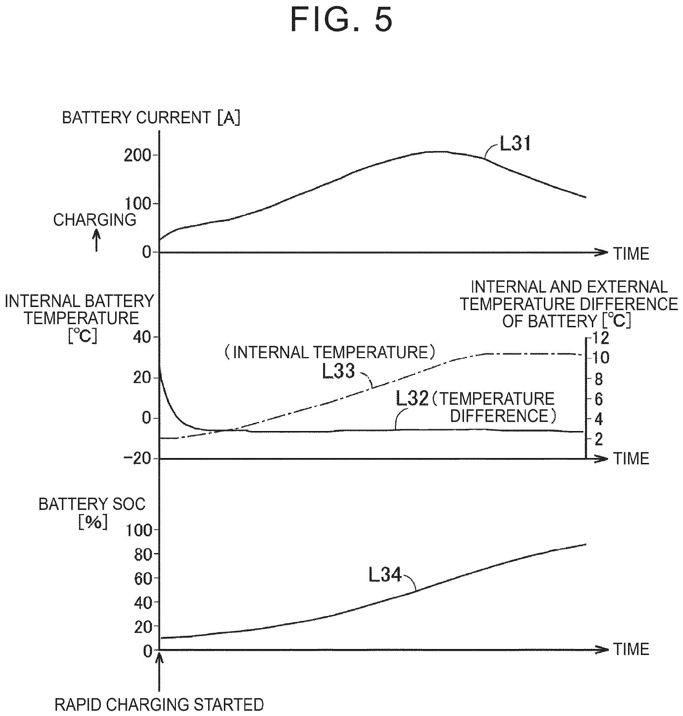

In the above equation, $dT(t + dt)$ represents the current value of the internal and external temperature difference of the cell 10 (the internal temperature of the cell 10 acquired in S13 shown in FIG. 2). As described above, the internal and external temperature difference of the cell 10 is expressed as a function of time t. $dT(0)$ is the initial value of the internal and external temperature difference of the cell 10. $dT(t)$ indicates a previous value of the internal and external temperature difference of the cell 10. dt indicates a calculation cycle of the ECU 500 (cycle in which steps S11 to S17 shown in FIG. 2 are repeated). In this embodiment, in the initial processing routine of the processing flow F1, fs obtained by the ECU 500 according to the map 511 (hereinafter referred to as "fs_IN") is set to $dT(0)$. At the start of rapid charging, the current of the cell 10 is a value that is 0 A or close to 0 A, and accordingly fs_IN matches the lower limit guard value (fs_MIN in FIG. 4) described above. During rapid charging, the internal and external temperature difference of the cell 10 tends to become smaller (see FIG. 5 described later). Accordingly, fs_IN is equivalent to the maximum value of the internal and external temperature difference of the cell 10. As described above, fs varies depending on $IB^2$ (see FIG. 4), and is determined based on the map 511. $\beta$ is a first-order lag coefficient relating to the thermal change of the cell 10. In this embodiment, a value $\beta$ found in advance (fixed value) is stored in the storage device of the ECU 500.

In S13 in FIG. 2, the processor of the ECU 500 uses the map 511 to acquire fs according to $IB^2$ acquired based on the output from the current sensor 43 (S12 in FIG. 2). Further, the processor of the ECU 500 substitutes the fs that is obtained into equation 512 to calculate $dT(t + dt)$. The calculated $dT(t + dt)$ is equivalent to the internal and external temperature difference of the cell 10.

During rapid charging, the temperature rise of the cell 10 is dominated by effects of the heat generated by metal parts of the cell 10. In detail, during rapid charging, a great current flows through the cell 10. In a cell 10 through which a great current flows, heat generated by the metal parts of the cell 10 is more likely to contribute to the temperature rise of the cell 10 than self-heating inside the cell 10. This is believed to be due to the heat capacity of the metal parts (positive terminal 13, negative terminal 14, etc.) being greater than the heat capacity of the electrode assembly (power storage unit 12). Heat generation in metal parts is little affected by anything other than current. Accordingly, the internal and external temperature difference of the cell 10 can be unambiguously found from the current of the cell 10. Accordingly, the ECU 500 finds fs from the current of the cell 10 as described above, and finds the internal and external temperature difference of the cell 10 from the fs that is obtained thereby.

The subtractor 513 illustrated in FIG. 3 is configured to subtract the internal and external temperature difference of the cell 10 from the temperature outside the cell 10. In this embodiment, the processor of the ECU 500 functions as the subtractor 513. A part of the electronic circuits making up the processor may function as the subtractor 513. The ECU 500 inputs the external temperature of the cell 10 (S11 in FIG. 2), acquired based on the output from the temperature sensor 41 and the $dT(t + dt)$ calculated as described above, to the subtractor 513. As a result, a value obtained by subtracting $dT(t + dt)$ from the external temperature of the cell 10 is output from the subtractor 513. The value output from the subtractor 513 is equivalent to the internal temperature of the cell 10. The estimator 510 estimates the internal temperature of the cell 10 as described above.

The calculator 520 illustrated in FIG. 3 calculates the charging-permitted current using the internal temperature of the cell 10 estimated by the estimator 510 and the SOC of the cell 10 (S14 in FIG. 2). In this embodiment, the processor in the ECU 500 functions as the calculator 520 by performing calculations based on maps stored in the storage device. The calculator 520 may acquire the charging-permitted current using maps indicated by each of lines L21, L22 in FIG. 3. Each of the maps shows a relation between the internal temperature of the cell 10 and the charging-permitted current. Line L21 shows the map relating to the cell 10 in a low SOC state. Line L22 shows the map relating to the cell 10 in a high SOC state. In the cell 10 in the low SOC state or the high SOC state, when the current (charging current) of the cell 10 exceeds the charging-permitted current indicated by lines L21, L22, respectively, lithium (Li) tends to be deposited within the cell 10. Li deposition accelerates deterioration of the cell 10.

For example, as shown by lines L21 and L22, in a region in which the internal temperature of the cell 10 is lower than a first temperature ("Te1" in FIG. 3), the higher the internal temperature of the cell 10 becomes, the further the calculator 520 raises the charging-permitted current. In a region in which the internal temperature of the cell 10 is equal to or higher than Te1 and is equal to or lower than Te2, the calculator 520 sets the charging-permitted current to a constant value (fixed value). Te2 is a second temperature that is higher than the first temperature. In a region in which the internal temperature of the cell 10 exceeds Te2, the higher the internal temperature of the cell 10 becomes, the further the calculator 520 lowers the charging-permitted current. Also, the calculator 520 reduces the charging-permitted current when the SOC of the cell 10 exceeds a predetermined value. The greater the SOC of the cell 10 becomes, the further the calculator 520 may lower the charging-permitted current.

The processing of S11 to S16 shown in FIG. 2 is repeatedly executed during rapid charging, such that the estimator 510 and the calculator 520 acquire the internal temperature and the charging-permitted current for each of the cells 10, respectively. In the processing of S13, the transient internal temperature of the cell 10 when the current (IB) of the cell 10 changes is acquired for each of the cells 10. In the processing of S15, the charging-permitted current for each of the cells 10 included in the battery pack 100 is successively acquired. The ECU 500 then transmits the smallest charging-permitted current among the charging-permitted currents acquired for each of the cells 10 to the control device 910 (S16 in FIG. 2).

As described above, the ECU 500 (management device) that manages the battery pack 100 acquires the internal and external temperature difference saturation value (fs) of the cell 10 at a constant current, based on the current of the cell 10 (battery) included in the battery pack 100. Also, the ECU 500 acquires the internal and external temperature difference of the cell 10 (dT(t + dt)) based on the internal and external temperature difference saturation value thereof that is acquired. Also, the ECU 500 acquires the internal temperature of the cell 10 based on the external temperature of the cell 10 and the internal and external temperature difference of the cell 10. According to this configuration, the internal temperature of the cell 10 can be estimated without using electrical resistance of the metal heat generating portion of the cell 10, which is difficult to identify. Accordingly, the ECU 500 can estimate the internal temperature of the cell 10 with high accuracy.

The ECU 500 is configured to repeatedly execute the processing of S11 to S16 shown in FIG. 2 when the vehicle 1000 is charging each battery included in the battery pack 100, using direct current electric power supplied from the EVSE 900. This enables charging rate to be improved while suppressing battery deterioration. Specifically, when the internal temperature of the cell 10 is erroneously detected as being on the high temperature side in a low temperature region (e.g., region below Te1 shown in FIG. 3), Li deposition tends to occur. Also, when the internal temperature of the cell 10 is erroneously detected as being on the high temperature side in a high temperature region (e.g., near Te2 shown in FIG. 3), the charging rate will be slowed down due to excessive current limitation. With respect to this point, the ECU 500 can estimate the internal temperature of the cell 10 with high accuracy, and accordingly can charge the cell 10 at a high rate while suppressing deterioration of the cell 10. In this embodiment, the processing of each of S11, S12, S15, and S16 shown in FIG. 2 is equivalent to an example of each of "first processing", "second processing", "sixth processing", and "seventh processing" according to the present disclosure, respectively (see FIG. 3). Also, the processing of S13 shown in FIG. 2 is equivalent to an example of "third processing", "fourth processing", and "fifth processing" according to the present disclosure (see FIGS. 3 and 4).

FIG. 5 shows data measured during rapid charging according to the processing flow F1 shown in FIG. 2. In FIG. 5, line L31 indicates transition of the current (charging current) of the cell 10 acquired in S12. Line L32 indicates transition of the internal and external temperature difference of the cell 10, output from equation 512 (FIG. 3) in S13. Line L33 indicates transition of the internal temperature of cell 10, output from the subtractor 513 (FIG. 3) in S13. Line L34 indicates transition in the SOC of the cell 10 acquired in S14. The horizontal axes of the graphs indicate elapsed time from the start of rapid charging. In the example shown in FIG. 5, at the start of rapid charging, the internal temperature of the cell 10 was -10 °C, and the SOC of the cell 10 was 10%. Actual measured data confirmed that both suppression of battery degradation and improvement of the charging rate were realized.

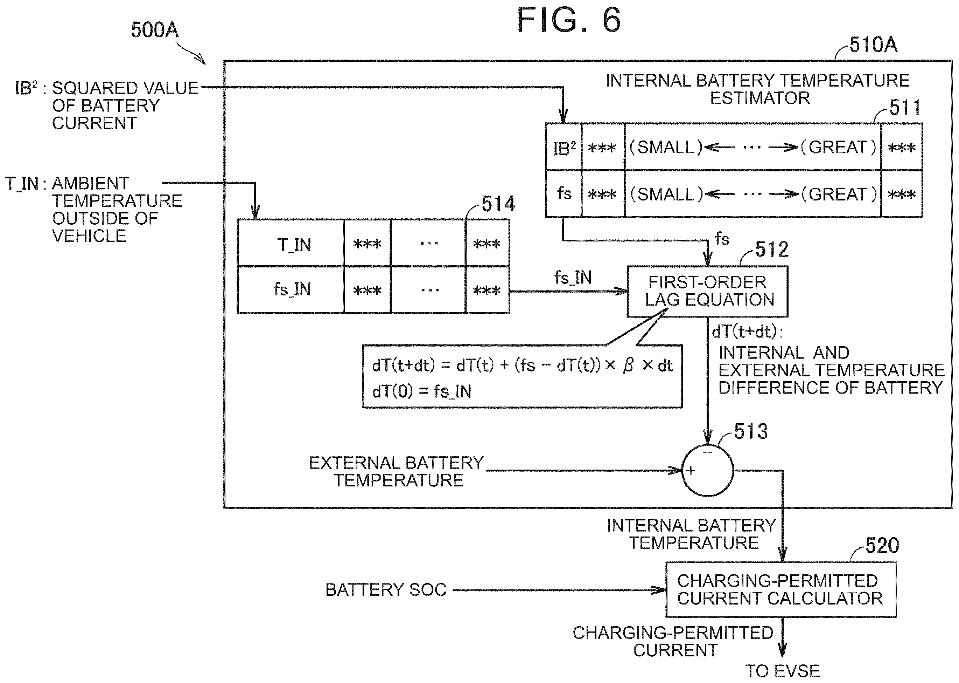

In the above embodiment, a fixed value equivalent to the lower limit guard value (fs_MIN in FIG. 4) is employed as the initial value of the internal and external temperature difference of the cell 10 (dT(0) in FIG. 3). However, this is not restrictive, and the initial value of the internal and external temperature difference of the cell 10 may be variable. FIG. 6 is a diagram illustrating a modification of the ECU 500 illustrated in FIG. 3.

With reference to FIG. 6, an ECU 500A according to the modification has basically the same configuration as the ECU 500 illustrated in FIG. 3, but includes an internal battery temperature estimator 510A (hereinafter simply referred to as "estimator 510A") instead of the estimator 510 illustrated in FIG. 3. In addition to the map 511, equation 512, and the subtractor 513, the estimator 510 A further includes a map 514. The map 514 defines a relation between the ambient temperature of the vehicle 1000 and fs_IN. The map 514 is created in advance through experiments or simulations, and is stored in a storage device of the ECU 500A. The ECU 500A uses the map 514 to acquire fs_IN corresponding to the ambient temperature of the vehicle 1000 detected by the outside air temperature sensor 45 ("T_IN" in FIG. 6). In this modification, fs_IN acquired by the map 514 is set to dT(0) in equation 512. Also, as long as $IB^2$ is $IB^2$_ST or lower in FIG. 4, fs_IN acquired by the map 514 is set to fs in equation 512. When $IB^2$ exceeds $IB^2$_ST, fs is set in accordance with the map 511 (line L14 in FIG. 4).

The ECU 500A according to the modification is configured to determine the initial value of the internal and external temperature difference of the cell 10 based on the ambient temperature of the vehicle 1000. This facilitates estimation of the internal temperature of the cell 10 with high accuracy, even when the ambient temperature of the vehicle 1000 suddenly changes. For example, when the vehicle 1000 is brought from outdoors into a warm garage (indoors) on a cold day, internal and external temperature difference of the cell 10 is likely to occur due to the change in the ambient temperature. Accordingly, there is a high likelihood that internal and external temperature difference of the cell 10 will remain when rapid charging is started indoors. Using the map 514 enables the internal and external temperature difference of the cell 10 at the start of charging to be acquired with high accuracy.

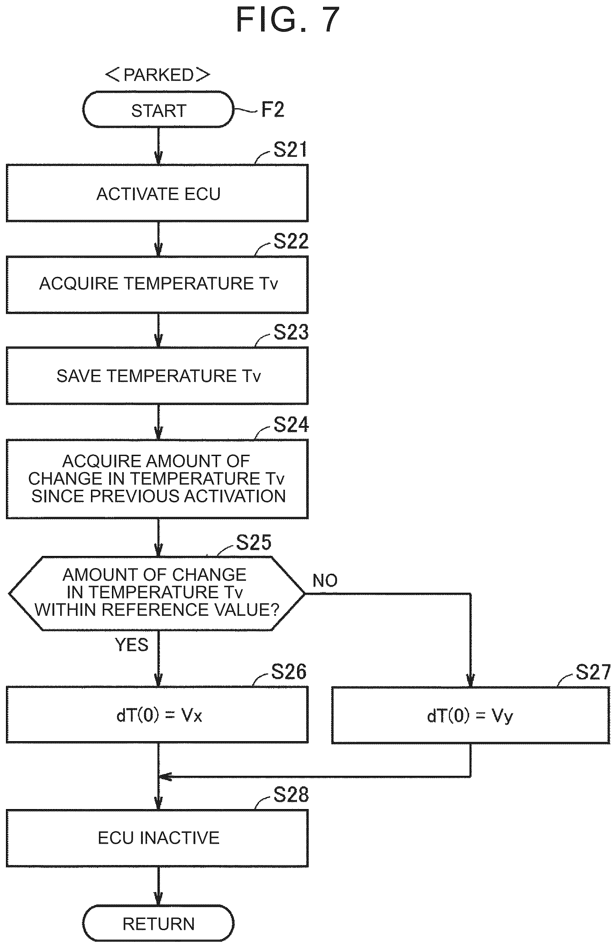

In the above embodiment, in the initial processing routine of the processing flow F1 shown in FIG. 2, the ECU 500 sets fs (fs_IN) obtained according to the map 511 as the initial value of the internal and external temperature difference of the battery (dT(0) in FIG. 3). However, this is not restrictive, and the ECU 500 illustrated in FIG. 3 may successively update the initial value of the internal and external temperature difference of the battery according to a processing flow F2 shown in FIG. 7 while the vehicle 1000 is parked. When the above-described rapid charging is started, the ECU 500 may then use the most recent initial value (dT(0)) set by the processing flow F2 instead of fs_IN, in the initial processing routine of the processing flow F1.

FIG. 7 is a flowchart showing a method for setting the initial value of the internal and external temperature difference of the battery while the vehicle is parked. When the vehicle 1000 is in a parked state, the ECU 500 goes to an inactive state (including a sleep state). While the vehicle 1000 is parked, the processing flow F2 shown in FIG. 7 is then started at a predetermined cycle. When the processing flow F2 starts, the ECU 500 is activated in S21. The ECU 500 that is activated executes the processing from S22 and thereafter.

In S22, the ECU 500 acquires a temperature Tv that correlates with the ambient temperature of the battery pack 100. Specifically, the ECU 500 may acquire the external temperature of the cell 10 detected by the temperature sensor 41 as the temperature Tv. Alternatively, the ECU 500 may acquire the ambient temperature of the vehicle 1000 detected by the outside air temperature sensor 45 as the temperature Tv. The ECU 500 functions as a battery management system (BMS) that monitors the battery pack 100.

In the following S23, the ECU 500 saves the temperature Tv detected in step S22 in association with the time of acquisition. Thus, data indicating the transition in the temperature Tv is stored in the storage device of ECU 500.

In the following S24, the ECU 500 acquires the difference (absolute value) between the previous value of the temperature Tv and the current value of the temperature Tv. The previous value of the temperature Tv is equivalent to the temperature Tv acquired in S23 of the previous processing routine. The current value of the temperature Tv is equivalent to the temperature Tv acquired in S23 of the current processing routine. The ECU 500 may read the previous value and the current value of the temperature Tv from the storage device, and then calculate the difference between the two values. In the initial processing routine, the ECU 500 may take the temperature Tv detected immediately before the initial processing routine is started as being the previous value of the temperature Tv. Hereinafter, the difference (absolute value) between the previous value and the current value of the temperature Tv calculated in S24 will be referred to as "amount of change in temperature Tv". The amount of change in temperature Tv is equivalent to the amount of change in the ambient temperature of battery pack 100 per unit time in the vehicle 1000 that is parked.

In the following S25, the ECU 500 determines whether the amount of change in the temperature Tv is within a predetermined reference value. When the amount of change in temperature Tv is within the reference value (YES in S25), the ECU 500 sets a first value (hereinafter referred to as "Vx") to dT(0) in S26. When the amount of change in temperature Tv is greater than the reference value (NO in S25), the ECU 500 sets a second value (hereinafter referred to as "Vy") to dT(0) in S27. Vx and Vy are different from each other. Vx may be a value that is smaller than Vy. dT(0) indicates the initial value of the internal and external temperature difference of the cell 10. The reference value may be a fixed value or may be variable. A determination of YES in S25 means that the ambient temperature of the battery pack 100 is not changing, or even when the ambient temperature is changing, the change is gradual.

When dT(0) is set by the processing of either S26 or S27, the ECU 500 goes into an inactive state (e.g., a sleep state) in S28, and then the processing flow F2 ends. Thereafter, when a predetermined time (unit time) has elapsed since the end of the processing flow F2, the processing flow F2 is started again. In this way, the ECU 500 is periodically activated and executes the processing flow F2. Thus, dT(0) is successively updated when parked. Vx or Vy is set to dT(0) based on the amount of change in temperature Tv, through the processing of S25 to S27.

In the above-described modification shown in FIG. 7, when the amount of change in the ambient temperature of the battery in the parked vehicle per unit time is smaller than a reference value, the ECU 500 (management device) sets the first value as the initial value of the internal and external temperature difference (S26), and when the amount of change in the environmental temperature of the battery in the parked vehicle per unit time is greater than the reference value, sets the second value that is different from the first value as the initial value (S27). Also, the ECU 500 (management device) acquires the internal and external temperature difference of the battery based on the initial value that is set and the internal and external temperature difference saturation value (e.g., see processing flow F1 shown in FIG. 2 and equation 512 shown in FIG. 3). The ECU 500 (management device) can acquire the internal and external temperature difference of the battery with high precision.

In the above embodiment, $\beta$ (first-order lag coefficient) in equation 512 is a fixed value. However, this is not restrictive, and $\beta$ may be variable. Specifically, there are some batteries in which the first-order delay during temperature rising and the first-order delay during temperature falling differ greatly, depending on the battery. Accordingly, the ECU 500 may determine whether the change in the internal temperature of the cell 10 is increase or decrease, and change the value of $\beta$ in equation 512 depending on whether the temperature is increasing or decreasing. Specifically, when the internal temperature of the cell 10 is acquired in S13 of FIG. 2, the ECU 500 may compare the acquired internal temperature of the cell 10 (current value) with the internal temperature of the cell 10 acquired in the previous processing routine (previous value), and may determine that "the temperature is rising" when the current value is higher than the previous value, or that "the temperature is falling" when the current value is lower than the previous value. The ECU 500 may then, based on the result of this determination, determine $\beta$ in equation 512 to be used in the next processing routine. In detail, when determining that the internal temperature of cell 10 is rising, the ECU 500 may set a first coefficient to $\beta$ in equation 512, and when determining that the internal temperature of cell 10 is decreasing, may set a second coefficient to $\beta$ in equation 512. The first coefficient and the second coefficient indicate values that are different from each other. These coefficients are found in advance by experiments or simulations and stored in the storage device of the ECU 500. According to the above configuration, estimation of the internal temperature of batteries is facilitated for a wide variety of batteries with high accuracy.

The processing flow F1 shown in FIG. 2 can be modified as appropriate. For example, the order of processing may be changed or unnecessary steps may be omitted, in accordance with purpose. For example, the processing of S11 may be executed after S12 (e.g., between S12 and S13).

The configuration of the vehicle is not limited to the configuration illustrated in FIG. 1. The vehicle is not limited to four-wheeled passenger cars, and may be busses or trucks instead. The management device may be used in vehicles other than automobiles (ships, aircraft, or the like), unmanned mobile bodies (such as automated guided vehicles, robots, and so forth), or buildings (such as dwelling houses, factories, and so forth).

The embodiment disclosed herein should be considered to be exemplary in all respects and not restrictive. The scope of the present invention is set forth in the claims rather than in the above description of the embodiment, and is intended to include all modifications within the meaning and scope equivalent to the claims.

## Claims

1. A management device for managing a battery, wherein
   the management device is configured to

   acquire an internal and external temperature difference saturation value of the battery at a constant current, based on a current of the battery,
   acquire an internal and external temperature difference of the battery, based on the internal and external temperature difference saturation value that is acquired, and
   acquire an internal temperature of the battery, based on an external temperature of the battery and the internal and external temperature difference of the battery.

2. The management device according to claim 1,

   the management device comprising a storage device that stores a map and a mathematical expression, wherein
   the map indicates a relation between a squared value of the current of the battery and the internal and external temperature difference saturation value,
the mathematical expression is a first-order lag equation relating to thermal change of the battery, and
the management device is configured to execute

first processing of acquiring the external temperature of the battery, based on output from a temperature sensor,
second processing of acquiring a squared value of the current of the battery, based on output from a current sensor,
third processing of using the map to acquire the internal and external temperature difference saturation value, in accordance with the squared value of the current of the battery that is acquired;
fourth processing of using the internal and external temperature difference saturation value that is acquired, and the mathematical expression, to acquire the internal and external temperature difference of the battery,
fifth processing of subtracting the internal and external temperature difference of the battery that is acquired, from the external temperature of the battery that is acquired,

such that the internal temperature of the battery is acquired.

3. The management device according to claim 2, wherein

the battery is installed in a vehicle,
the vehicle is configured to receive supply of direct current electric power from a power supply facility that is outside of the vehicle, in a parked state, and to charge the battery using the direct current electric power while being supplied with the direct current electric power, and
the management device is configured to further execute

sixth processing of acquiring an upper limit value of a charging current using the internal temperature of the battery acquired by the first to fifth processing, and
seventh processing of transmitting the upper limit value of the charging current that is acquired, to the power supply facility, and

the management device is configured to repeatedly execute the first to seventh processing while the vehicle is charging the battery using the direct current electric power supplied from the power supply facility.

4. The management device according to claim 3, wherein

the mathematical expression defines a current value of the internal and external temperature difference of the battery in accordance with a previous value of the internal and external temperature difference of the battery,
the management device is configured to determine an initial value of the internal and external temperature difference of the battery based on an ambient temperature of the vehicle.

5. The management device according to any one of claims 2 to 4, wherein

the mathematical expression includes a first-order lag coefficient relating to thermal change of the battery, and
the management device is configured to
set a first coefficient as the first-order lag coefficient when the internal temperature of the battery is rising, and
set a second coefficient that is different from the first coefficient, as the first-order lag coefficient, when the internal temperature of the battery is decreasing.

6. The management device according to claim 1, wherein

the battery is installed in a vehicle, and
the management device is configured to

set a first value as an initial value of the internal and external temperature difference when an amount of change in ambient temperature per unit time of the battery in the parked vehicle is smaller than a reference value,
set a second value that is different from the first value, as the initial value when the amount of change in ambient temperature per unit time of the battery in the parked vehicle is greater than the reference value, and
acquire the internal and external temperature difference of the battery based on the initial value that is set, and the internal and external temperature difference saturation value.

# FIG. 1

# FIG. 2

# FIG. 3

IB² : SQUARED VALUE OF BATTERY CURRENT

## 510 INTERNAL BATTERY TEMPERATURE ESTIMATOR

### 511

| IB² | *** | (SMALL) ◄····► (GREAT) | *** |
|-----|-----|------------------------|-----|
| fs  | *** | (SMALL) ◄····► (GREAT) | *** |

fs → 512

### FIRST-ORDER LAG EQUATION

dT(t+dt) :
INTERNAL AND EXTERNAL TEMPERATURE DIFFERENCE OF BATTERY

513

EXTERNAL BATTERY TEMPERATURE

INTERNAL BATTERY TEMPERATURE

$$dT(t+dt) = dT(t) + (fs - dT(t)) \times \beta \times dt$$

fs : INTERNAL AND EXTERNAL TEMPERATURE DIFFERENCE SATURATION VALUE OF BATTERY

$\beta$ : FIRST-ORDER LAG COEFFICIENT

dt : COMPUTATION CYCLE

$$dT(0) = fs\_IN$$

fs_IN : INITIAL VALUE OF INTERNAL AND EXTERNAL TEMPERATURE DIFFERENCE OF BATTERY

### 520 CHARGING-PERMITTED CURRENT CALCULATOR

BATTERY SOC →

CHARGING-PERMITTED CURRENT
TO EVSE

CHARGING-PERMITTED CURRENT

Li DEPOSITION REGION

L21

SOC RISES

L22

INTERNAL BATTERY TEMPERATURE

Te1  Te2

EP 4 779 754 A1

13

FIG. 4

BATTERY CURRENT (IB) IS CONSTANT

TEMPERATURE

L11 (OUTSIDE OF BATTERY)

L12 (INSIDE OF BATTERY)

TIME

INTERNAL AND EXTERNAL TEMPERATURE DIFFERENCE OF BATTERY

SATURATION

L13

fs

TIME

fs

fs_MIN

L14

L14a

$IB^2$_ST

$IB^2$

# FIG. 5

BATTERY CURRENT [A]

200-

100-

CHARGING

↑

0-

L31

→ TIME

INTERNAL BATTERY TEMPERATURE [°C]

INTERNAL AND EXTERNAL TEMPERATURE DIFFERENCE OF BATTERY [°C]

40-

20-

0-

-20-

（INTERNAL TEMPERATURE）
L33

L32（TEMPERATURE DIFFERENCE）

12
10
8
6
4
2

→ TIME

BATTERY SOC [%]

100-
80-
60-
40-
20-
0-

L34

→ TIME

RAPID CHARGING STARTED

# FIG. 6

500A

510A

IB² : SQUARED VALUE
OF BATTERY
CURRENT

INTERNAL BATTERY TEMPERATURE
ESTIMATOR

511

| IB² | *** | (SMALL) ←⋯→ (GREAT) | | *** |
| fs | *** | (SMALL) ←⋯→ (GREAT) | | *** |

T_IN : AMBIENT
TEMPERATURE
OUTSIDE OF
VEHICLE

514

| T_IN | *** | ⋯ | *** |
| fs_IN | *** | ⋯ | *** |

fs

512

fs_IN → FIRST-ORDER
LAG EQUATION

$$dT(t+dt) = dT(t) + (fs - dT(t)) \times \beta \times dt$$
$$dT(0) = fs\_IN$$

dT(t+dt) :
INTERNAL AND
EXTERNAL TEMPERATURE
DIFFERENCE OF BATTERY

513

EXTERNAL BATTERY
TEMPERATURE

INTERNAL BATTERY
TEMPERATURE

520

BATTERY SOC → CHARGING-PERMITTED
CURRENT CALCULATOR

CHARGING-PERMITTED
CURRENT

TO EVSE

EP 4 779 754 A1

# FIG. 7

<PARKED>

START — F2

S21

ACTIVATE ECU

S22

ACQUIRE TEMPERATURE Tv

S23

SAVE TEMPERATURE Tv

S24

ACQUIRE AMOUNT OF
CHANGE IN TEMPERATURE Tv
SINCE PREVIOUS ACTIVATION

S25

AMOUNT OF CHANGE
IN TEMPERATURE Tv
WITHIN REFERENCE VALUE?

NO

YES

S26

dT(0) = Vx

S27

dT(0) = Vy

S28

ECU INACTIVE

RETURN

17

Europäisches
Patentamt

European
Patent Office

Office européen
des brevets

# EUROPEAN SEARCH REPORT

**Application Number**

EP 25 22 7441

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 115 201 688 A (NARI RELAYS ELECTRIC CO LTD; NANJING NARI RELAYS ENG TECH) 18 October 2022 (2022-10-18) | 1 | INV. H01M10/48 G01R31/367 |
| Y | * the whole document * * | 2-6 | |
| | ----- | | |
| Y | US 2024/391356 A1 (DOKE TOSHIO [JP]) 28 November 2024 (2024-11-28) * paragraphs [0036] - [0046]; figure 2 * | 2-6 | |
| | ----- | | |
| A | EP 3 683 084 A1 (TOYOTA MOTOR CO LTD [JP]) 22 July 2020 (2020-07-22) * paragraphs [0055] - [0080] * | 3 | |
| | ----- | | |
| X | SHI HAOTIAN ET AL: "A novel lumped thermal characteristic modeling strategy for the online adaptive temperature and parameter co-estimation of vehicle lithium-ion batteries", JOURNAL OF ENERGY STORAGE ELSEVIER BV, NL, vol. 50, 2 March 2022 (2022-03-02), XP087057648, ISSN: 2352-152X, DOI: 10.1016/J.EST.2022.104309 [retrieved on 2022-03-02] | 1 | |
| Y | * pages 1-6 * | 2-6 | |
| | ----- | | |

**TECHNICAL FIELDS SEARCHED (IPC)**

G01R
B60H
H01M

The present search report has been drawn up for all claims

| Place of search | Date of completion of the search | Examiner |
|---|---|---|
| The Hague | 1 June 2026 | Standaert, Frans |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

# EP 4 779 754 A1

## ANNEX TO THE EUROPEAN SEARCH REPORT
## ON EUROPEAN PATENT APPLICATION NO.

EP 25 22 7441

This annex lists the patent family members relating to the patent documents cited in the above-mentioned European search report.
The members are as contained in the European Patent Office EDP file on
The European Patent Office is in no way liable for these particulars which are merely given for the purpose of information.

01-06-2026

| Patent document cited in search report | | Publication date | Patent family member(s) | | Publication date |
|---|---|---|---|---|---|
| CN 115201688 | A | 18-10-2022 | NONE | | |
| US 2024391356 | A1 | 28-11-2024 | CN | 119017998 A | 26-11-2024 |
| | | | JP | 7708144 B2 | 15-07-2025 |
| | | | JP | 2024168168 A | 05-12-2024 |
| | | | US | 2024391356 A1 | 28-11-2024 |
| EP 3683084 | A1 | 22-07-2020 | CN | 111439166 A | 24-07-2020 |
| | | | EP | 3683084 A1 | 22-07-2020 |
| | | | JP | 7163785 B2 | 01-11-2022 |
| | | | JP | 2020115715 A | 30-07-2020 |
| | | | US | 2020231060 A1 | 23-07-2020 |

EPO FORM P0459

For more details about this annex : see Official Journal of the European Patent Office, No. 12/82

**EP 4 779 754 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018170144 A